Europäisches Patentamt

European Patent Office

Office européen des brevets

(19)

(11) Veröffentlichungsnummer : **0 038 464**
**B1**

(12) **EUROPÄISCHE PATENTSCHRIFT**

(45) Veröffentlichungstag der Patentschrift :
05.10.83

(21) Anmeldenummer : 81102603.8

(22) Anmeldetag : 07.04.81

(51) Int. Cl.³ : **H 04 N 9/535**, H 03 K 13/02

(54) **Farbfernseh-Empfänger mit mindestens einer integrierten Schaltung zur Trennung und Aufbereitung des Luminanzsignals und der Chrominanzsignale aus dem Farb-Bild-Austast-Synchron-Signalgemisch (FBAS-Signal).**

(30) Priorität : 19.04.80 DE 3015141

(43) Veröffentlichungstag der Anmeldung :
28.10.81 Patentblatt 81/43

(45) Bekanntmachung des Hinweises auf die Patenterteilung : 05.10.83 Patentblatt 83/40

(84) Benannte Vertragsstaaten :
FR GB IT NL

(56) Entgegenhaltungen :
AT B 351 090
DE A 2 401 452

(73) Patentinhaber : ITT INDUSTRIES INC.
320 Park Avenue
New York, NY 10022 (US)

(72) Erfinder : Flamm, Peter Michael
Stefan-Meier-Strasse 167
D-7800 Freiburg (DE)

(74) Vertreter : Stutzer, Gerhard, Dr.
Deutsche ITT Industries GmbH Patent- und Lizenzabteilung Hans-Bunte-Strasse 19 Postfach 840
D-7800 Freiburg (DE)

Farbfernseh-Empfänger mit mindestens einer integrierten Schaltung zur Trennung und Aufbereitung des Luminanzsignals und der Chrominanzsignale aus dem Farb-Bild-Austast-Synchron-Signalgemisch (FBAS-Signal)

Die Erfindung betrifft einen Farbfernseh-Empfänger mit mindestens einer integrierten Schaltung zur Trennung und Aufbereitung des Luminanzsignals und der Chrominanzsignale aus dem Farb-Bild-Austast-Synchronsignal-Gemisch (FBAS-Signal) entsprechend dem Oberbegriff des Anspruchs 1. Ein wesentliches Kennzeichen einer älteren nationalen Anmeldung nach DE-OS 28 54 236, angemeldet am 15.12.78 und veröffentlicht am 26.6.80 (sowie den Parallelanmeldungen FR-A-2 444 387 und GB-A-2 038 138), besteht in der Verwendung eines Analog-Digital-Wandlers, dessen Analogeingang das FBAS-Signal zugeführt ist und der von einem Taktsignal mit der vierfachen Farbhilfsträgerfrequenz getaktet ist, so daß in denjenigen Zeitpunkten aus den Amplituden des FBAS-Signals ein Parallel-Binärwort als Ausgangssignal entsteht, in denen die jeweiligen Amplituden des nichtdemodulierten Chrominanzsignals den Amplituden des jeweiligen Farbdifferenzsignals gleich sind.

Dafür wird ein Parallel-Analog-Digital-Wandler wegen der hohen, zu verarbeitenden Frequenzen benötigt. Derartige schnelle Parallel-Analog-Digital-Wandler sind bekanntlich so aufgebaut, daß $2^s-1$ Differenzverstärker (vgl. D.F. Hoeschele, « Analog-to-Digital/Digital-to-Analog Conversions Techniques », New York, 1968, S. 10) als Komparator vorgesehen sind, wobei mit s die Anzahl der Binärstellen des digitalen Wandler-Ausgangssignals bezeichnet ist. Die nichtinvertierenden (oder die invertierenden) Eingänge aller Differenzverstärker liegen dabei gemeinsam am FBAS-Signal, während die invertierenden (oder die nichtinvertierenden) Eingänge aufeinanderfolgend an den Abgriffen eines zwischen einer konstanten Referenzspannung und dem Schaltungsnullpunkt liegenden ohmschen Spannungsteilers angeschlossen sind, der aus $2^s$ oder $2^s-1$ gleichen Widerständen besteht.

Ein 6-Bit-Parallel-Analog-Digital-Wandler hat somit 63 Komparatoren und 63 Widerstände, ein 7-Bit-Wandler schon 127 und ein 8-Bit-Wandler 255 Komparatoren bzw. Widerstände. Es ist ohne weiteres ersichtlich, daß mit steigender Stellenzahl die integrierte Realisierung derartiger Wandler schnell unwirtschaftlich wird. Insbesondere kann bei Reduzierung um eine Stelle der Aufwand halbiert werden.

Die Aufgabe der Erfindung besteht daher darin, bei einer Anordnung nach dem Oberbegriff des Anspruchs 1 eine Reduzierung des Aufwandes an Komparatoren und Widerständen auf die Hälfte zu erzielen, ohne die digitale Auflösung zu beeinträchtigen. Mit anderen Worten soll also mit der Erfindung ermöglicht werden, beispielsweise eine 6-Bit-Auflösung mit einem 5-Bit-Wandler zu erreichen. Dies geschieht durch Anwendung der im Kennzeichen des Anspruchs 1 angegebenen Merkmale. Dabei wird auf das im genannten Buch, S. 413-415 beschriebene Prinzip zurückgegriffen.

Die Erfindung wird nun anhand der Figuren der Zeichnung näher erläutert.

Figur 1 zeigt das Blockschaltbild der Schaltung nach Fig. 1 der älteren nationalen Anmeldung,

Figur 2 zeigt verschiedene in der Anordnung nach Fig. 1 auftretende Signalverläufe und ferner tabellenartig an bestimmten Schaltungspunkten zu bestimmten Zeitpunkten auftretende Signalarten, und

Figur 3 zeigt das Blockschaltbild einer Ausführungsform der Erfindung.

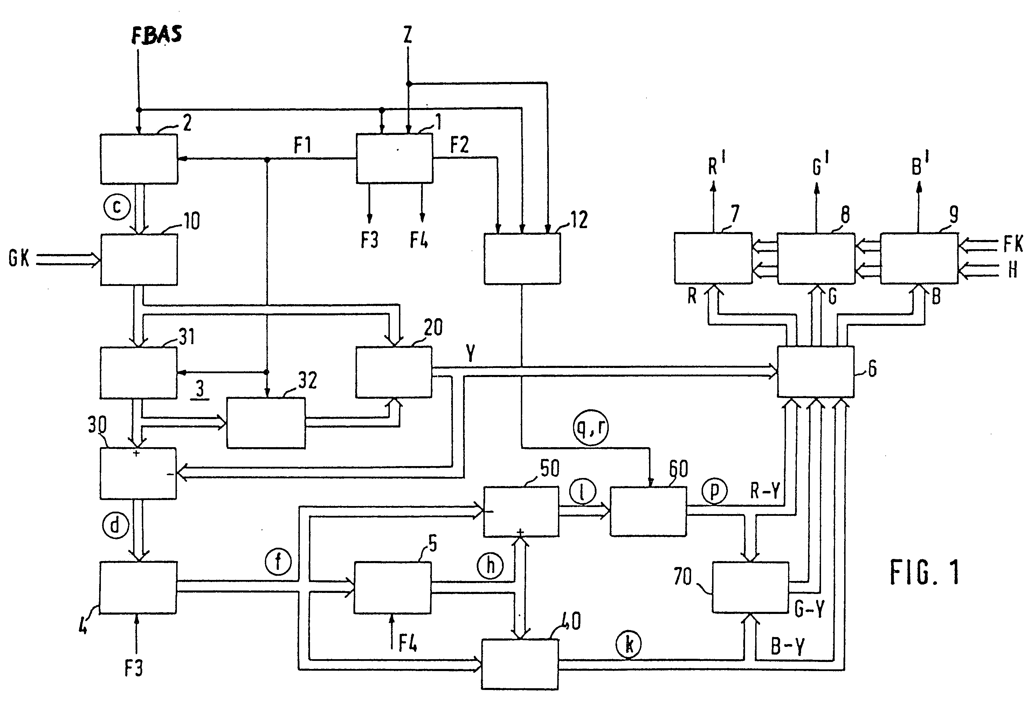

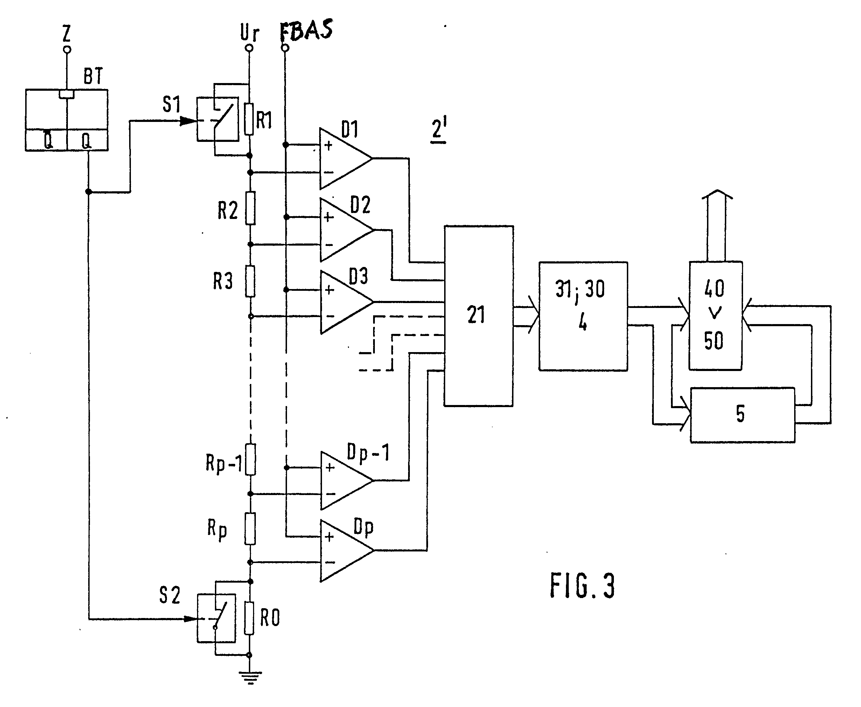

In den in Form von Blockschaltbildern gezeichneten Fig. 1 und 3 sind gleiche Teile mit gleichen Bezugszeichen versehen. Ferner zeigen diese Figuren außer den in Schaltbildern üblichen strichförmigen Verbindungsleitungen solche mit streifenartiger Ausbildung. Durch diese streifenförmigen Verbindungsleitungen soll zum Ausdruck kommen, daß es sich hierbei um Verbindungen zwischen digitalen Parallelausgängen des abgebenden Schaltungsteils und digitalen paralleleingängen des aufnehmenden Schaltungsteils handelt. Die streifenförmigen Verbindungsleitungen bestehen daher aus mindestens so vielen Einzelleitungen, wie das weiterzuleitende Binärwort Bits aufweist. Die auf den streifenförmigen Leitungen der Fig. 1 und 3 weitergegebenen Signale sind somit sämtlich Binärsignale, deren momentaner Binärwert dem im FBAS-Signal und weiteren Signalen enthaltenen Momentan-Analog-Signalwert entspricht.

Der auf übliche Weise aus dem FBAS-Signal gewonnene Farbhilfsträger F steuert in Fig. 1 wie bei bekannten Farbfernsehempfängern den Farbhilfsträger-Quarzoszillator, also den sogenannten FHT-Oszillator, der als Rechtecksignal-Taktgenerator 1 ausgebildet ist. Durch den bekanntlich im FBAS-Signal enthaltenen sogenannten Burst wird der Taktgenerator 1 auf die gesendete Farbhilfsträgerfrequenz synchronisiert. Der Taktgenerator 1 erzeugt das Taktsignal F1, dessen Frequenz der vierfachen Farbhilfsträgerfrequenz entspricht, also bei CCIR-Norm etwa 17,73 MHz beträgt (genau 17,734 475 MHz).

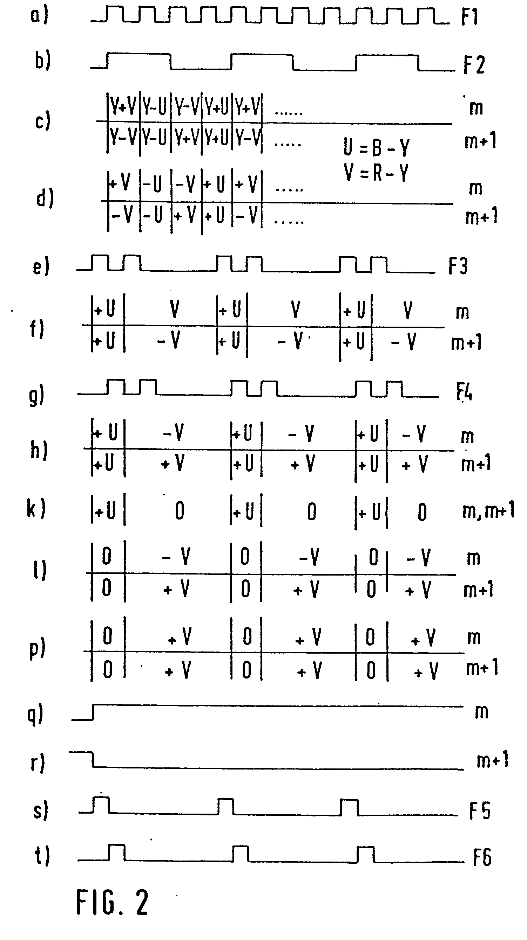

Der Taktgenerator 1 erzeugt ferner das rechteckförmige Taktsignal F2 mit der Farbhilfsträgerfrequenz. Erstes und zweites Taktsignal F1, F2 haben das Tastverhältnis 0,5 (vgl. Fig. 2a und b). Ferner werden das dritte Taktsignal F3 und das vierte Taktsignal F4 erzeugt, die jeweils aus zwei T/2-langen, im Abstand T/2 aufeinanderfolgenden Impulsen innerhalb jeder 4T-langen Periode bestehen, wobei mit T die Periodendauer des ersten Taktsignals F1 bezeichnet ist. Das dritte und vierte Taktsignal F3, F4 sind in Fig. 2b und g gezeigt.

Die einzelnen Taktsignale werden innerhalb des Taktgenerators 1 in üblicher Weise mittels bekannter Digitaltechniken erzeugt. So kann beispielsweise das Taktsignal F1 mittels eines entsprechenden 17,73 MHz-Quarzes erzeugt werden, und daraus können durch Frequenzteilung und entsprechende Impulsunterdrückung die Taktsignale F2, F3, F4 gebildet werden. Wie bei bekannten Farbfernsehempfängern wird dem Taktgenerator 1 auch noch ein aus der Zeilenendstufe stammender Impuls Z zugeführt, während dessen Dauer der Taktgenerator 1 durch den Burst synchronisiert wird.

Das FBAS-Signal wird ferner dem Analogeingang des vom ersten Taktsignal F1 getakteten Analog-Digital-Wandlers 2 zugeführt, der zu Beginn jedes Impulses des ersten Taktsignals F1 aus dessen Amplitude ein Parallel-Binärwort als Ausgangssignal bildet. Diese Vorderflanken der Impulse des ersten Taktsignals F1 sind zeitlich so gelegt und treten somit in denjenigen Zeitpunkten auf, in denen die jeweiligen Amplituden des nichtdemodulierten, im FBAS-Signal enthaltenen Chrominanzsignals den Amplituden des jeweiligen Farbdifferenzsignals gleich sind.

Diese Parallel-Binärwörter werden dann für die jeweilige Periodendauer T des ersten Taktsignals F1 nicht mehr verändert, also sozusagen wie bei einer Abtast-Halteschaltung gehalten. Die am Ausgang des Analog-Digital-Wandlers 2 auftretenden Signale sind in Fig. 2c tabellarisch angegeben, wobei die senkrechten Striche die jeweiligen Taktperioden des ersten Taktsignals F1 symbolisieren. In Fig. 1 ist der zugehörige Buchstabe von Fig. 2 ebenfalls angegeben und eingekreist.

Nach Fig. 2c ergeben sich in einer Zeile m während einer Periode des zweiten Taktsignals F2 die aufeinanderfolgenden Signale Y + V, Y − U, Y − V und Y + U, wobei U, V und Y die an sich angegebenen formalen Bedeutungen, nämlich U = B − Y, V = R − Y, B = Blau-Chrominanzsignal, R = Rot-Chrominanzsignal und Y = Luminanzsignal, haben, jedoch hier die entsprechenden digitalisierten Signale, also wiederum die entsprechenden Binärworte bedeuten. Als zweite Zeile sind in der Tabelle der Fig. 2c die entsprechenden Binärsignale in der Zeile m + 1 angegeben, nämlich die während der betrachteten Taktperiode des Taktsignals F2 auftretenden Signale Y − V, Y − U, Y + V und Y + U.

Dieses Ausgangssignal des Analog-Digital-Wandlers 2 liegt nun am einen Eingang der ersten Binär-Rechenstufe 10, die dieses Ausgangssignal mit einem binären Gesamtkontrast-Einstellsignal GK multipliziert. Dieses Gesamtkontrast-Einstellsignal entspricht somit dem bei üblichen Farbfernsehempfängern vorhandenen analogen Einstellsignal mit derselben Funktion. Das binäre Gesamtkontrast-Einstellsignal GK liegt bei heute üblichen Farbfernsehempfängern ebenso wie das unten noch zu erläuternde binäre Farbsättigungs-Einstellsignal FK und das binäre Helligkeits-Einstellsignal H bereits in digitaler Form vor, da üblicherweise Fernbedienungen und digitale Einstellorgane vorhanden sind, die diese Signale abgeben.

Ein Vorteil der Schaltung nach Fig. 1 ist also darin zu sehen, daß diese Signale an ihrem Wirkungsort nicht mehr analog aufbereitet werden müssen.

Das Ausgangssignal der ersten Binär-Rechenstufe 10 wird nun einerseits der zweiten Binär-Rechenstufe 20 und andererseits dem zweistufigen Verzögerungsglied 3 zugeführt, das dieses Ausgangssignal um T/2 versögert. Die zweite Binär-Rechenstufe 20 bildet aus dem verzögerten und aus dem unverzögerten Signal den arithmetischen Mittelwert. Bei dieser Funktion wird von dem Grundgedanken ausgegangen, daß ein sinusförmiges Signal, nämlich der Farbträger, mit der doppelten Frequenz abgetastet als Mittelwert zweier aufeinanderfolgender Abtastwerte immer den Wert Null ergibt. Somit wird durch die arithmetische Mittelwertbildung in der zweiten Binär-Rechenstufe 20 der Farbhilfsträger unterdrückt und bereits das Luminanzsignal Y in digitaler Form gewonnen.

Das in der ersten Verzögerungsstufe 31 des Verzögerungsglieds 3 um dessen halbe Verzögerungsdauer, also um T/4, verzögerte Ausgangssignal der ersten Binär-Rechenstufe 10 wird dann ebenso wie das Ausgangssignal der zweiten Binär-Rechenstufe 20 der dritten Binär-Rechenstufe 30 zugeführt, die das letztgenannte Signal, also das Y-Signal, vom erstgenannten Signal subtrahiert. Dadurch entsteht am Ausgang der dritten Binär-Rechenstufe 30 das Chrominanzsignal mit den aufeinanderfolgenden Komponenten B − Y, R − Y, -(B − Y) und -(R − Y), wie dies in Fig. 2d für die Zeilen m und m + 1 tabellarisch angegeben ist.

Diese Signale werden der Pufferspeicheranordnung 4 zugeführt, deren Übernahmeeingang das dritte Taktsignal F3 zugeführt ist, das in Fig. 2e gezeigt ist. Dieser Pufferspeicher arbeitet so, daß das zu Beginn eines jeden Impulses des dritten Taktsignals F3 gerade am Eingang anstehende Binärwort bis zum nächsten Taktimpuls an den Ausgang gelegt wird. Somit ergeben sich die in Fig. 2f bezüglich der Zeilen m und m + 1 tabellarisch angegebenen momentanen Ausgangssignale. Als einzelne Stufen der Pufferspeicheranordnung können beispielsweise sogenannte D-Flipflops dienen.

Das Ausgangssignal der Pufferspeicheranordnung 4 ist dann der aus n parallelen Schieberegistern bestehenden Schieberegisteranordnung 5 zugeführt, wobei n die Anzahl der Bits am Ausgang der dritten Binär-Rechenstufe 30 ist.

Die Verzögerung der n parallelen Schieberegister ist jeweils gleich der Dauer einer Zeile, bei PAL-Fernsehgeräten also gleich 64 µs. Den Takteingängen der n parallelen Schieberegister ist das vierte Taktsignal F4 zugeführt, das in Fig. 2g gezeigt ist. Das Ausgangssignal der Schieberegisteranordnung 5 ist in Fig. 2h tabellarisch für die Zeilen m und m + 1 angegeben.

Dieses Ausgangssignal wird der vierten Binär-Rechenstufe 40 zusammen mit dem Eingangssignal der Schieberegisteranordnung 5 zugeführt, die daraus den arithmetischen Mittelwert bildet, so daß an deren Ausgang bereits das Signal B − Y in digitaler Form entsteht, das in Fig. 2k tabellarisch angegeben ist. Das Ausgangssignal der Schieberegisteranordnung 5 wird ferner zusammen mit deren Eingangssignal der fünften Binär-Rechenstufe 50 zugeführt, die das letztgenannte vom erstgenannten subtrahiert und durch zwei teilt. Mittels der Teilung durch zwei wird ebenfalls eine Art Mittelwertbildung erreicht.

Das Ausgangssignal der fünften Binär-Rechenstufe 50 ist in Fig. 2l tabellarisch angegeben, wiederum jeweils für die Zeilen m und m + 1. Dieses Ausgangssignal wird der sechsten Binär-Rechenstufe 60 zugeführt, die es in Abhängigkeit von dem ihr ebenfalls zugeführten Ausgangssignal des PAL-Umschalters 12 in der einen Zeile unbeeinflußt läßt und in der anderen Zeile dessen Betrag bildet. Unter Betragsbildung ist hierbei zunächst der aus der Mathematik bekannte Begriffsinhalt zu verstehen, daß nämlich bei einer negativen Zahl das negative Vorzeichen unterdrückt wird und nur der positive Zahlenwert dieser negativen Zahl berücksichtigt wird. Hier ist unter Betrag jedoch auch zu verstehen : « Betrag bezüglich einer konstanten Zahl ». Damit ist gemeint, daß für eine Zahl A, die unterhalb der Konstanten X liegt, der « Betrag bezüglich X » gleich 2X − A ist. Bezüglich der Zahl 50 ist also der « Betrag bezüglich 50 » von 30 gleich 70. Am Ausgang der sechsten Binär-Rechenstufe 60 entsteht somit in digitaler Form das PAL-kompensierte Signal R − Y, also das Rot-Luminanz-Differenzsignal, das in Fig. 2p tabellarisch für die Zeilen m und m + 1 angegeben ist.

Schließlich werden die Ausgangssignale der vierten Binär-Rechenstufe 40 und der sechsten Binär-Rechenstufe 60 der siebten Binär-Rechenstufe 70 zugeführt, die daraus das Grün-Luminanz-Differenzsignal G − Y nach der bekannten Formel $Y = 0,3 R + 0,59 G + 0,11 B$ bildet.

Die Teilschaltungen 5, 40, 50, 60 und 70 stellen in Verbindung mit dem PAL-Umschalter 12 den Schaltungsteil zur Phasenkorrektur des empfangenen Signals nach dem PAL-Verfahren dar.

Die Ausgangssignale der zweiten, vierten, sechsten und siebten Binär-Rechenstufen 20, 40, 60, 70, also das Luminanzsignal Y und die Farbdifferenzsignale B − Y, R − Y und G − Y, werden dann der Binär-R-G-B-Matrix 6 zugeführt, die daraus die binären Chrominanzsignale R, G, B entsprechend der erwähnten Formel bildet. Diese binären Chrominanzsignale werden dann schließlich jeweils einem der drei Digital-Analog-Wandler 7, 8, 9 zugeführt, die die binären Chrominanzsignale in die zur R-G-B-Steuerung der Bildröhre erforderlichen analogen Chrominanzsignale R', G', B' umformen.

Jedem dieser Digital-Analog-Wandler ist nach Fig. 1 außerdem das Farbsättigungs-Einstellsignal FK und das Helligkeits-Einstellsignal H jeweils in binärer Form zugeführt. Der PAL-Umschalter 12 erhält als Eingangssignale das zweite Taktsignal F2, also ein Signal mit der auf den Burst synchronisierten Farbhilfsträgerfrequenz, ferner das FBAS-Signal und den aus der Zeilenendstufe stammenden Referenzimpuls Z zugeführt.

In Fig. 3 ist das Blockschaltbild einer möglichen Ausführungsform der Erfindung gezeigt. Der Analog-Digital-Wandler 2 ist als Parallel-Analog-Digital-Wandler 2' ausgebildet und enthält die als Komparatoren dienenden Differenzverstärker D1, D2, D3, Dp-1, Dp, ferner die zu einem Spannungsteiler hintereinandergeschalteten Widerstände R1, R2, R3, Rp-1, Rp, R0 sowie den Decoder-Teil 21, der aus den Ausgangssignalen der Komparatoren die entsprechenden Binärwörter bildet. Der rechts von dem Decoder-Teil 21 liegende Teil in Fig. 3 gibt stark zusammengefaßt und vereinfacht die Schaltungsteile der darin angegebenen Bezugszeichen aus Fig. 1 wieder.

Der Parallel-Analog-Digital-Wandler 2' enthält $p = 2^r − 1$ Differenzverstärker und die entsprechende Anzahl Widerstände, wobei r die um eins verminderte Anzahl der Binärstellen des Ausgangssignals des Analog-Digital-Wandlers 2 nach Fig. 1 ist. Soll dieser also z. B. 8 Bit abgeben, so ist r gleich 7. Die Widerstände R2 ... Rp sind untereinander gleich und haben den Wert R, während die Widerstände R0, R1 den Wert 0,5 R haben.

Entsprechend der Erfindung wird die auf die Komparatoren einwirkende Referenzspannung Ur, die im Ausführungsbeispiel der Fig. 3 auf alle invertierenden Eingänge einwirkt, dadurch während jeder zweiten Zeile um den Betrag $\Delta U = 0,5 \ Ur/2^r$ verschoben, daß parallel zum Widerstand R1 und parallel zum Widerstand R0 jeweils die elektronischen Schalter S1 bzw. S2 liegen, die alternativ zueinander geöffnet bzw. geschlossen sind. Ihr Steuersignal stammt von einem der Ausgänge Q, Q̄ des Binärteilers BT, dem die Zeilensynchron- oder die Zeilenrückschlagimpulse Z zugeführt sind.

Anstatt die Referenzspannung Ur in der geschilderten Weise zu verschieben, kann auch der Änderungsbetrag ΔU in einer Analog-Addierstufe dem FBAS-Signal während jeder zweiten Zeile hinzuaddiert werden. Dann bleibt die Referenzspannung Ur dauernd konstant.

Durch die Beeinflussung der Referenzspannung Ur während jeder zweiten Zeile ist in Zusammenwirken mit der vierten oder der fünften Binär-Rechenstufe 40 bzw. 50 und der als Verzögerungsstufe wirkenden Schieberegisteranordnung 5, die genau um eine Zeilendauer verzögert, die beabsichtigte Wirkung erzielt, die Anzahl der eigentlich erforderlichen Komparatoren um die Hälfte zu reduzieren und trotzdem eine Auflösung zu erreichen, die einer Auflösung mit einer zusätzlichen Binärstelle entspricht, da am Ausgang der vierten oder fünften Binär-Rechenstufe 40 bzw. 50 der Mittelwert aus zwei aufeinanderfolgenden Zeilensignalen gebildet wird.

Das anhand von Fig. 3 erläuterte Prinzip kann auch auf den Luminanzkanal angewendet werden, wenn ein Kammfilter und eine Verzögerungsanordnung mit einer Verzögerungszeit einer Zeilendauer in diesem Kanal vorgesehen

werden.

## Anspruch

Farbfernsehempfänger mit mindestens einer integrierten Schaltung zur Trennung und Aufbereitung des Luminanzsignals und der Chrominanzsignale aus dem Farb-Bild-Austast-Synchron-Signalgemisch (FBAS-Signal), die
— den Farbhilfsträger-Quarzoszillator (FHT-Oszillator),
— den Farbhilfsträger-Bandpaß,
— den Synchrondemodulator,
— den PAL-Umschalter,
— die Farb-Matrix und gegebenenfalls
— die R-G-B-Matrix enthält
und deren einer digitalen Signalaufbereitung dienende Teilschaltungen folgende Merkmale aufweisen :
— der FHT-Oszillator ist ein Rechtecksignal-Taktgenerator (1) für vier Taktsignale (F1, F2, F3, F4), deren erstes (F1) die vierfache FHT-Frequenz und deren erstes (F1) die vierfache FHT-Frequenz und deren zweites bis viertes (F2, F3, F4) die FHT-Frequenz haben, wobei das erste und das zweite Taktsignal (F1, F2) das Tastverhältnis 0,5 haben und das dritte und vierte Taktsignal (F3, F4) jeweils aus zwei T/2-langen, im Abstand T/2 aufeinanderfolgenden Impulsen innerhalb jeder 4T-langen Periode besteht, wobei T gleich der Periodendauer des ersten Taktsignals ist,
— ein vom ersten Taktsignal (F1) getakteter Analog-Digital-Wandler (2), an dessen Analogeingang das FBAS-Signal liegt und der in denjenigen Zeitpunkten aus dessen Amplitude ein Parallel-Binärwort als Ausgangssignal bildet, in denen die jeweiligen Amplituden des nichtdemodulierten Chrominanzsignals den Amplituden des jeweiligen Farbdifferenzsignals gleich sind,
— eine erste Binär-Rechenstufe (10), die das Ausgangssignal des Analog-Digital-Wandlers (2) mit einem binären Gesamtkontrast-Einstellsignal (GK) multipliziert,
— ein zweistufiges Verzögerungsglied (3), das das Ausgangssignal der ersten Binär-Rechenstufe (10) um T/2 verzögert,
— eine zweite Binär-Rechenstufe (20), die den arithmetischen Mittelwert aus dem verzögerten und aus dem nichtverzögerten Ausgangssignal der ersten Binär-Rechenstufe (10) bildet,
— eine dritte Binär-Rechenstufe (30), die das Ausgangssignal der zweiten Binär-Rechenstufe (20) vom Ausgangssignal der ersten Verzögerungsstufe (31) subtrahiert,
— eine Pufferspeicheranordnung (4) für das Ausgangssignal der dritten Binär-Rechenstufe (30), deren Übernahmeeingang das dritte Taktsignal (F3) zugeführt ist,
— eine Schieberegisteranordnung (5) aus n parallelen Schieberegistern (n = Anzahl der Bits am Ausgang der dritten Binär-Rechenstufe), die jeweils eine Verzögerung von der Dauer einer Zeile haben und deren Serieneingänge mit den Parallelausgängen der Pufferspeicheranordnung (4) verbunden sind sowie deren Takteingängen das vierte Taktsignal (F4) zugeführt ist,
— eine vierte Binär-Rechenstufe (40), die den arithmetischen Mittelwert aus dem Eingangs- und dem Ausgangssignal der Schieberegisteranordnung (5) bildet,
— eine fünfte Binär-Rechenstufe (50), die das Eingangssignal der Schieberegisteranordnung (5) von deren Ausgangssignal subtrahiert und danach durch zwei teilt,
— eine sechste Binär-Rechenstufe (60), die, gesteuert vom PAL-Umschalter (12), das Ausgangssignal der fünften Binär-Rechenstufe (50) entweder unbeeinflußt läßt oder dessen Betrag bildet,
— eine siebte Binär-Rechenstufe (70), die aus den Ausgangssignalen der vierten und der sechsten Binär-Rechenstufe (40, 60) das Grün-Leuchtdichte-Differenzsignal (G-Y) bildet,
— an den Ausgängen der zweiten, vierten, sechsten und siebten Binär-Rechenstufe (20, 40, 60, 70) liegt die Binär-R-G-B-Matrix (6) und an deren Ausgängen jeweils einer von drei Digital-Analog-Wandlern (7, 8, 9) zur Gewinnung der analogen Signale für eine R-G-B-Steuerung der Bildröhre, oder
— an den Ausgängen der zweiten, vierten, sechsten und siebten Binär-Rechenstufe (20, 40, 60, 70) liegt jeweils einer von vier Digital-Analog-Wandlern zur Gewinnung der analogen Signale für eine Farbdifferenz-Steuerung der Bildröhre, gekennzeichnet durch folgende Merkmale :
— der Analog-Digital-Wandler (2) ist ein Parallel-Analog-Digital-Wandler (2') mit $p = 2^r - 1$ Differenzverstärkern (D1 ... Dp) als Komparatoren, wobei r die um eins verminderte Anzahl der Binärstellen des Ausgangssignals des Analog-Digital-Wandlers (2) ist und die nichtinvertierenden (oder invertierenden) Eingänge der p Differenzverstärker (D1 ... Dp) gemeinsam das FBAS-Signal als Eingangssignal zugeführt erhalten und deren invertierende (oder nichtinvertierende) Eingänge aufeinanderfolgend an den Abgriffen eines ohmschen Spannungsteilers angeschlossen sind, der untereinander gleiche Widerstände (R2 ... Rp) enthält und dem eine Referenzspannung (Ur) zugeführt ist, und
— für die Dauer jeder zweiten Zeile ist entweder die Referenzspannung (Ur) oder das FBAS-Eingangssignal um $\Delta U = 0,5\ Ur/2^r$ verschoben.

## Claim

Colour-television receiver comprising at least one integrated circuit for separating and conditioning the luminance signal and the chrominance signals from the composite colour signal, said integrated circuit containing
— a chrominance-subcarrier oscillator,
— a chrominance-subcarrier band-pass filter,
— a synchronous demodulator,
— a PAL switch,
— a colour matrix, and, if necessary
— a R-G-B matrix, and

subcircuits conditioning digital signals and having the following features :

— the chrominance-subcarrier oscillator is a square-wave clock generator (1) providing four clock signals (F1, F2, F3, F4) the first of which (F1) has four times the chrominance-subcarrier frequency and the second to fourth of which (F2, F3, F4) have the chrominance-subcarrier frequency, with the first and the second clock signals (F1, F2) having a pulse duty factor of 0.5, and the third and fourth clock signal (F3, F4) each consisting of two consecutive, T/2-long pulses separated by T/2 within each 4T-long period, T being equal to the period of the first clock signal ;

— an analog-to-digital converter (2) clocked by the first clock signal (F1), whose analog input is presented with the composite colour signal, and which forms as its output signal a parallel binary word from the amplitude of the composite colour signal at the instants the respective amplitudes of the undemodulated chrominance signal are equal to the amplitudes of the respective colour-difference signal ;

— a first binary arithmetic stage (10) which multiplies the output signal of the analog-to-digital converter (2) by a binary overall-contrast control signal (GK) ;

— a two-stage delay line (3) which delays the output signal of the first binary arithmetic stage (10) by T/2 ;

— a second binary arithmetic stage (20) which forms the arithmetic mean of the delayed and undelayed output signals of the first binary arithmetic stage (10) ;

— a third binary arithmetic stage (30) which subtracts the output signal of the second binary arithmetic stage (20) from the output signal of the first delay stage (31) ;

— a buffer-memory arrangement (4) which temporarily stores the output signal of the third binary arithmetic stage (30), and whose enable input is fed with the third clock signal (F3) ;

— a shift-register arrangement (5) consisting of n parallel shift registers (n = number of bits at the output of the third binary arithmetic stage (30)), each of which provides a delay of one line period and whose serial inputs are connected to the parallel outputs of the buffer-memory arrangement (4), while their clock inputs are fed with the fourth clock signal (F4) ;

— a fourth binary arithmetic stage (40) which forms the arithmetic mean of the input and output signals of the shift-register arrangement (5) ;

— a fifth binary arithmetic stage (50) which subtracts the input signal of the shift-register arrangement (5) from the output signal of this arrangement and then divides the difference by two ;

— a sixth binary arithmetic stage (60) which, controlled by the PAL switch, either leaves the output signal of the fifth binary arithmetic stage (50) unchanged or forms its absolute value ;

— a seventh binary arithmetic stage (70) which forms the green colour-difference signal from the output signals of the fourth and sixth binary arithmetic stages (40, 60) ;

— the outputs of the second, fourth, sixth and seventh binary arithmetic stages (20, 40, 60, 70) are connected to the binary R-G-B matrix (6) each of whose outputs is coupled to one of three digital-to-analog converters (7, 8, 9) for deriving the analog signals for controlling the R-G-B values of the picture tube, or

— the outputs of the second, fourth, sixth and seventh binary arithmetic stages (20, 40, 60, 70) are each connected to one of four digital-to-analog converters for deriving the analog signals for controlling the colour-difference values of the picture tube,

characterized by the following features :

— the analog-to-digital converter (2) is a parallel analog-to-digital converter (2') with $p = 2^r - 1$ differential amplifiers (D1 to Dp) as comparators, where r is the number of binary digits of the output signal of the analog-to-digital converter (2) minus one, the composite colour signal being applied as the input signal to the noninverting (or inverting) inputs of all p differential amplifiers (D1 to Dp), and the inverting (noninverting) inputs of the differential amplifiers (D1 to Dp) being connected successively to the taps of a resistive voltage divider which contains equal-value resistors (R2 to Rp) and is fed with a reference voltage (Ur), and

— for the duration of every second line, either the reference voltage (Ur) or the composite colour input signal is shifted by $\Delta U = 0.5 \ Ur/2^r$.

## Revendication

Récepteur de télévision en couleurs, comportant au moins un circuit intégré pour séparer et traiter le signal de luminance et les signaux de chrominance à partir du signal composite « couleur-image-suppression-synchronisation », ce module contenant :

— l'oscillateur à quartz de sous-porteuse couleurs,

— le filtre passe-bande de sous-porteuse couleurs,

— le démodulateur synchrone,

— le commutateur PAL,

— la matrice couleurs, et éventuellement

— la matrice R-V-B,

des circuits partiels de ce module servant au traitement numérique des signaux ayant les particularités suivantes :

— l'oscillateur de sous-porteuse couleurs est un générateur d'horloge (1) à signaux rectangulaires, fournissant quatre signaux d'horloge (F1, F2, F3, F4), le premier (F1) ayant une fréquence quadruple de celle de la sous-porteuse, et les deuxième, troisième et quatrième signaux d'horloge (F2, F3, F4) ayant la fréquence de cette sous-porteuse, le premier et le deuxième signal d'horloge (F1, F2) ayant un rapport cyclique de 0,5 tandis que le troisième et le quatrième signal d'horloge (F3, F4) consistent chacun en deux impulsions longues de T/2 se succédant à intervalles de T/2 à l'intérieur de chaque période de durée 4T, T étant la durée d'une période du premier signal d'horloge,

— un convertisseur analogique/numérique (2) rythmé par le premier signal d'horloge (F1) reçoit, à son entrée analogique, ledit signal composite et forme, à partir de l'amplitude de celui-ci, un signal de sortie sous la forme d'un mot binaire parallèle, cela aux instants où les amplitudes respectives du signal de chrominance non démodulé et du signal différence de couleurs respectif sont égales,

— un premier étage de calcul binaire (10) qui multiplie le signal de sortie du convertisseur analogique/numérique (2) par un signal binaire (GK) de réglage de contraste global,

— un élément retardateur (3) à deux étages, qui retarde de T/2 le signal de sortie du premier étage (10) de calcul binaire,

— un deuxième étage (20) de calcul binaire qui forme la moyenne arithmétique du signal de sortie retardé du premier étage de calcul binaire (10) et du signal de sortie non retardé de ce même étage (10),

— un troisième étage (30) de calcul binaire qui soustrait le signal de sortie du deuxième étage (20) de calcul binaire du signal de sortie du premier étage retardateur (31),

— un dispositif de mémoire tampon (4) pour le signal de sortie du troisième étage de calcul binaire (30), l'entrée de prise en charge de ce dispositif de mémoire-tampon recevant le troisième signal d'horloge (F3),

— un dispositif (5) à registres à décalage, constitué de n registres à décalage en parallèle (n étant égal au nombre des bits de la sortie du troisième étage de calcul binaire), lesquels registres à décalage ont chacun un retard égal à la durée d'une ligne et ont leurs entrées série reliées aux sorties parallèles du dispositif de mémoire-tampon (4), tandis que leurs entrées d'horloge reçoivent le quatrième signal d'horloge (F4),

— un quatrième étage de calcul binaire (40) qui forme la moyenne arithmétique du signal d'entrée et du signal de sortie du dispositif (5) à registres à décalage,

— un cinquième étage de calcul binaire (50) qui soustrait le signal d'entrée du dispositif (5) à registres à décalage du signal de sortie de ce même dispositif, et effectue une division par deux,

— un sixième étage de calcul binaire (60) qui, commandé par le commutateur PAL (12), tantôt laisse le signal de sortie du cinquième étage de calcul binaire (50) inchangé, tantôt forme la valeur absolue de celui-ci,

— un septième étage de calcul binaire (70) qui, à partir des signaux de sortie du quatrième et du sixième étage de calcul binaire (40, 60), forme le signal de différence « vert-luminance » (V-Y),

— les sorties des deuxième, quatrième, sixième et septième étages de calcul binaire (20, 40, 60, 70) sont connectées à la matrice R-V-B binaire (6) dont chacune des sorties est couplée respectivement à l'un de trois convertisseurs numérique/analogique (7, 8, 9), lesquels fournissent les signaux analogiques pour la commande des valeurs R-V-B du tube image, ou bien

— aux sorties respectives du deuxième, du quatrième et du septième étages de calcul binaire (20, 40, 60, 70) sont raccordés respectivement l'un de quatre convertisseurs numérique/analogique pour obtenir les signaux analogiques destinés à une commande par différence de couleur du tube image,

ce récepteur étant caractérisé en ce que :

— le convertisseur analogique/numérique (2) est un convertisseur (2') comportant, en tant que comparateurs, un nombre $p = 2^r - 1$ d'amplificateurs différentiels (D1 à Dp), r étant le nombre des bits, diminué de 1, du signal de sortie du convertisseur analogique/numérique (2), les entrées non inverseuses (ou inverseuses) des p amplificateurs différentiels (D1 à Dp) recevant toutes, en tant que signal d'entrée, le signal composite d'entrée, et les entrées inverseuses (ou non inverseuses) de ces amplificateurs différentiels étant raccordées aux prises de sortie d'un diviseur de tension résistif à plusieurs résistances égales entre elles (R2 ... Rp), ce diviseur de tension recevant une tension de référence (Ur), et

— pendant la durée d'une ligne sur deux, la tension de référence (Ur) ou le signal composite d'entrée est décalé de $U = 0,5\ Ur/2^r$.

FIG. 1

0 038 464

a) ⎍⎍⎍⎍⎍⎍⎍⎍⎍ F1

b) ⎍⎍⎍⎍ F2

c)

| Y+V | Y-U | Y-V | Y+U | Y+V | ...... | | m |
|-----|-----|-----|-----|-----|--------|---|-----|
| Y-V | Y-U | Y+V | Y+U | Y-V | ..... | | m+1 |

$$U = B - Y$$
$$V = R - Y$$

d)

| +V | -U | -V | +U | +V | ..... | m |
|----|----|----|----|----|-------|-----|
| -V | -U | +V | +U | -V | ..... | m+1 |

e) ⎍⎍  ⎍⎍  ⎍⎍ F3

f)

| +U | V | +U | V | +U | V | m |
|----|-----|----|------|----|------|-----|
| +U | -V | +U | -V· | +U | -V | m+1 |

g) ⎍⎍  ⎍⎍  ⎍⎍ F4

h)

| +U | -V | +U | -V | +U | -V | m |
|----|----|----|----|----|----|-----|
| +U | +V | +U | +V | +U | +V | m+1 |

k)

| +U | 0 | +U | 0 | +U | 0 | m,m+1 |

l)

| 0 | -V | 0 | -V | 0 | -V | m |
|---|----|---|----|---|----|-----|
| 0 | +V | 0 | +V | 0 | +V | m+1 |

p)

| 0 | +V | 0 | +V | 0 | +V | m |
|---|----|---|----|---|----|-----|
| 0 | +V | 0 | +V | 0 | +V | m+1 |

q) ‾‾‾‾‾‾‾‾‾‾‾‾ m

r) ‾‾‾‾‾‾‾‾‾‾‾‾ m+1

s) ⎍   ⎍   ⎍ F5

t)  ⎍   ⎍   ⎍ F6

# FIG. 2

FIG. 3